(19) Europäisches Patentamt

European Patent Office

Office européen des brevets

(11) Veröffentlichungsnummer: **0 307 990**

**A1**

(12) **EUROPÄISCHE PATENTANMELDUNG**

(21) Anmeldenummer: **88201867.4**

(22) Anmeldetag: **01.09.88**

(51) Int. Cl.⁴: **H05K 3/30**

(30) Priorität: **11.09.87 DE 3730498**

(43) Veröffentlichungstag der Anmeldung:
**22.03.89 Patentblatt 89/12**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

㉞ **DE**

(71) Anmelder: **N.V. Philips' Gloeilampenfabrieken**
**Groenewoudseweg 1**
**NL-5621 BA Eindhoven(NL)**

㉞ **FR GB**

(72) Erfinder: **Werner, Jillek, Dr.**
**Memelstrasse 45**
**D-8520 Erlangen(DE)**

(74) Vertreter: **Peuckert, Hermann, Dipl.-Ing. et al**
**Philips Patentverwaltung GmbH**
**Wendenstrasse 35 Postfach 10 51 49**
**D-2000 Hamburg 1(DE)**

(54) Oberflächenmontierbares Bauelement mit Kleberbeschichtung.

(57) Die Erfindung (1) betrifft ein oberflächenmontierbares Bauelement (SMD) mit an der Unterseite angebrachter Kleberschicht (3), zur Bestückung von
Leiterplatten.

Es wird vorgeschlagen einen Kleber (3) zu verwenden, der bei Raumtemperatur fest und nicht klebefähig ist und dessen Klebefähigkeit unmittelbar
vor dem Bestückungsvorgang durch Wärmezufuhr
aktivierbar ist.

## Oberflächenmontierbares Bauelement mit Kleberbeschichtung

Die Erfindung betrifft ein oberflächenmontierbares Bauelement (SMD) mit an der Unterseite angebrachter Kleberschicht zur Bestückung von Leiterplatten.

Für oberflächenmontierbare Bauelemente ist auch die Kurzbezeichnung SMD, abgeleitet von Surface Mounted Device, gebräuchlich. Ein derartiges oberflächenmontierbares Bauelement, welches tauchlötfähig ist, ist in der DE-A 32 32 659 beschrieben. Es weist an seinen Seitenflächen zwei lötfähige Kontaktschichten auf. An der Unterseite des Bauelements sind mittels einer ausgehärteten klebenden Schicht Mikrokapseln befestigt, welche vorzugsweise einen schnell härtenden Zyanacrylatkleber enthalten. Wird ein solches Bauelement beim Bestücken einer Leiterplatte auf diese aufgedrückt, so zerplatzen die Mikrokapseln und der Kleber tritt aus der Mikrokapsel auf die Platine aus.

Das Aufbringen einer Kleberschicht bereits bei der Herstellung des SMD bringt eine Reihe von Vorteilen. Für das Festhalten eines SMD auf einer Leiterplatte vor dem Wellenlötvorgang ist je nach der Beschaffenheit des SMD eine unterschiedliche Menge von Kleber erforderlich. Bei der Bestückung von Leiterplatten mit SMDs ist es üblich, in einem vorgeschalteten Arbeitsgang den Kleber auf der Leiterplatte aufzubringen. Da jedoch eine Leiterplatte mit einer Vielzahl unterschiedlicher SMDs zu bestücken ist, bereitet die unterschiedliche Dosierung des Klebers für jede einzelne Klebestelle erhebliche Schwierigkeiten. Außerdem erfordert das Aufbringen des Klebers bei der Vielzahl von SMDs, die auf einer Leiterplatte unterbringbar sind, einen nicht zu vernachlässigenden Zeitaufwand.

Beim Aufbringen der Kleberschicht unmittelbar auf der Unterseite eines SMD bereits beim Herstellen des SMD ist darauf zu achten, daß ein ungehinderter Transport und eine ungehinderte Lagerung möglich sind. Es muß daher bei einem gemäß DE-A 32 32 659 mit einer Kleberschicht versehenen Bauelement darauf geachtet werden, daß nicht durch unbeabsichtigte Druckeinwirkungen Kleber austritt und zu einem unerwünschten Verkleben der Mikrokapseln führt.

Wegen der sich durch die Verwendung eines schnell härtenden Zyanacrylatklebers ergebenden Schwierigkeiten ist in der DE-A 34 25 724 vorgeschlagen worden, einen Zweikomponentenkleber zu verwenden, dessen Komponenten in jeweils getrennten Mikrokapseln enthalten sind.

Bei der Herstellung eines SMD mit einer Kleberschicht an seiner Unterseite, dessen Kleber aus einem Zweikomponentenkleber besteht, dessen beide Komponenten in jeweils getrennten Mikrokapseln enthalten sind, ist es schwierig, eine sorgfältige Durchmischung der beiden Mikrokapseln im richtigen Verhältnis zu erzielen. Außerdem ist bei der Bestückung einer Leiterplatte mit derartigen SMD ein hoher Druck auf das SMD auszuüben, damit die Kapseln zuverlässig zum Bersten gebracht werden und eine gute Vermengung der Komponenten des Zweikomponentenklebers erfolgt. Hierdurch besteht die Gefahr, daß die SMDs selbst eine Beschädigung erleiden.

Der Erfindung liegt die Aufgabe zugrunde, ein oberflächenmontierbares Bauelement (SMD) der eingangs genannten Art so zu verbessern, daß bei der Herstellung des SMD ein einfacher Auftrag eines Klebers in jeweils an die Geometrie des SMD angepaßter Menge problemlos möglich ist und bei der Bestückung einer Leiterplatte mit derart ausgerüsteten SMDs kein nennenswerter Druck auf das SMD anzuwenden ist.

Diese Aufgabe wird gemäß der Erfindung dadurch gelöst, daß der Kleber bei Raumtemperatur fest und nicht klebefähig ist und die Klebefähigkeit durch Wärmezufuhr aktivierbar ist.

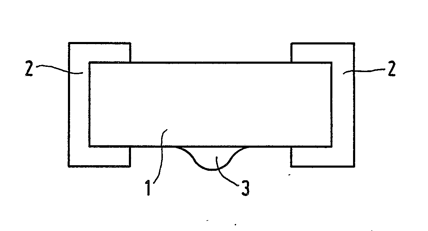

Im folgenden soll die Erfindung anhand des in der Figur gezeigten Ausführungsbeispiels beschrieben werden.

Die Figur zeigt ein SMD mit an seiner Unterseite aufgebrachter Kleberschicht von der Seite.

Das mit 1 bezeichnete SMD ist an zwei gegenüberliegenden Schmalseiten in üblicher Weise mit lötfähigen Metallisierungen 2 versehen, welche nach dem Bestücken in einem Lötvorgang mit Anschlußflächen auf einer Leiterplatte verlötet werden. Das Verlöten selbst erfolgt im Wellenlötverfahren. Hierzu ist es erforderlich, daß das SMD vor dem Verlöten zuverlässig auf der Leiterplatte befestigt wird, vorzugsweise durch Kleben. Zu diesem Zweck ist auf der unmetallisierten Unterseite des SMD 1 eine Kleberschicht 3 aufgebracht. Die Kleberschicht hat eine an die Größe des SMD und an die Form der Metallisierung angepaßte Form. Einerseits ist es notwendig, daß das Bauteil zuverlässig auf der Leiterplatte angeklebt ist, wozu eine große mit dem Kleber bedeckte Fläche erwünscht ist. Andererseits darf der Kleber die Metallisierung nicht überdecken, damit eine zuverlässige Lötung erfolgt. Durch die Anbringung des Klebers bei der Herstellung des SMD kann eine je nach Bauelementtyp individuelle und sehr präzise einhaltbare Dosierung des Klebers und eine je nach Anwendungsfall gestaltbare Ausformung der Kleberschicht erfolgen. Die Kleberschicht kann beispielsweise halbkugelförmig, zylindrisch, rechteckig oder kegelförmig sein. Die Höhe der Kleberschicht ist jeweils so zu bemessen, daß sie die Beauteilmetallisierung 2 geringfügig überragt.

Der Kleber ist bei Raumtemperatur fest und inaktiv. Somit besteht weder bei Transport noch bei Lagerung die Gefahr, daß eine unerwünschte Verklebung eines SMD mit der Verpackung oder mit anderen in der gleichen Verpackung untergebrachten SMDs erfolgt.

Unmittelbar vor dem Bestückungsvorgang wird die Kleberschicht aktiviert. Hierzu sind in bekannter Weise eine Vielzahl von erprobten Möglichkeiten anwendbar. So kann die Erwärmung der Kleberschicht gezielt durch einen HeißGas-Strahl, durch Kontaktwärme, durch Infrarotwärme oder mittels Laserstrahl schnell erfolgen, ohne daß das SMD selbst unnötig erwärmt wird. Danach wird das SMD auf die Leiterplatte aufgesetzt. Eine nennenswerte Druckeinwirkung auf das SMD erfolgt nicht. Die Aushärtung des Klebers auf der Leiterplatte erfolgt je nach gewählter Kleberart ebenfalls in bekannter Weise, z.B. bei Raumtemperatur, durch Einwirkung von UV-Licht oder durch erneute Wärmezufuhr.

Die Weiterverarbeitung der bestückten Leiterplatte erfolgt anschließend beispielsweise nach einem bekannten Wellenlötverfahren.

Die in der Figur gezeigte Bauform eines SMD hat keine Anschlußfahnen, jedoch ist die Erfindung nicht auf diese Bauform beschränkt, sondern ebenso auf andere Bauformen anwendbar, wie sie z.B. unter den Bezeichnungen SO und SOT bekannt sind. Bei SMDs mit größeren Abmessungen kann es zweckmäßig sein, mehrere Klebepunkte anzubringen.

**Ansprüche**

1. Oberflächenmontierbares Bauelement (SMD) mit auf der Unterseite angebrachter Kleberschicht, zur Bestückung von Leiterplatten,
dadurch gekennzeichnet,
daß der Kleber bei Raumtemperatur fest und nicht klebefähig ist und die Klebefähigkeit durch Wärmezufuhr aktivierbar ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,X | FR-A-2 609 232 (TDK CORP)<br>* Seite 5, Zeilen 24-30; Seite 7, Zeile 18 - Seite 8, Zeile 11; Seite 9, Zeilen 8-11; Seite 10, >Zeilen 17-30; Seite 13, Zeilen 5-7; Anspruch 1 * & GB-A-2 200 801 *<br>--- | 1 | H 05 K 3/30 |
| A | FR-A-2 514 983 (INTERNATIONAL STANDARD ELECTRIC CORP.)<br>* Seite 3, Zeilen 13-27 *<br>--- | 1 | |
| A | EP-A-0 127 682 (MATSUSHITA ELECTRIC INDUSTRIEL)<br>* Seite 3, Zeilen 3-7; Anspruch 1 *<br>----- | 1 | |

**RECHERCHIERTE SACHGEBIETE (Int. Cl.4)**

H 05 K

Der vorliegende Recherchenbericht wurde für alle Patentansprüche erstellt

| Recherchenort | Abschlußdatum der Recherche | Prüfer |
|---|---|---|
| DEN HAAG | 08-12-1988 | MOMENE Y ARROYO M.E. |

EPO FORM 1503 03.82 (P0403)